Europäisches Patentamt

European Patent Office

Office européen des brevets

(11) Publication number: **0 055 017**
**B1**

(12) **EUROPEAN PATENT SPECIFICATION**

(45) Date of publication of patent specification: **21.01.87**

(51) Int. Cl.⁴: **G 11 C 19/08**

(21) Application number: **81305196.8**

(22) Date of filing: **30.10.81**

(54) **Magnetic bubble memory cassette.**

(30) Priority: **30.10.80 JP 155135/80**

(43) Date of publication of application:
**30.06.82 Bulletin 82/26**

(45) Publication of the grant of the patent:
**21.01.87 Bulletin 87/04**

(84) Designated Contracting States:
**DE FR GB**

(56) References cited:
**US-A-4 156 934**

**IBM TECHNICAL DISCLOSURE BULLETIN,
volume 21, no. 7, December 1978, NEW YORK
(US) J.D. LARNERD "Bubble domain package"
pages 2714-2715**

(73) Proprietor: **FUJITSU LIMITED**
**1015, Kamikodanaka Nakahara-ku
Kawasaki-shi Kanagawa 211 (JP)**

(72) Inventor: **Sukeda, Toshiaki**
**406-3, Hakata-cho Susaka-shi
Nogano 382 (JP)**
Inventor: **Naoi, Shiro**
**3-141, Aza Minamihara Oaza Koyama
Suzaka-shi Nagano 382 (JP)**
Inventor: **Maegawa, Harumi**
**837-7, Shimoaso Tama-ku
Kawasaki-shi Kanagawa 215 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

The present invention relates to a magnetic bubble memory cassette.

In a non-volatile large-capacity memory device, a high reliability is desirable for storing and holding a large quantity of information. Although a magnetic tape device or magnetic disc device can provide a non-volatile large-capacity memory device, such a device has a disadvantage in that it involves movable parts, which tend to reduce its reliability. In contrast, a magnetic bubble memory device can provide a non-volatile large-capacity memory device having a high reliability.

Relatively small and light magnetic bubble memory devices are known, for example, from IBM Technical Disclosure Bulletin Vol. 21, No. 7, December 1978, pages 2714/2715, and from a paper by Mavity and McCarthy in "Elektronik", No. 11, 1 May 1979, pages 45—52 entitled "Magnetblasenspeicher — Bausteine und Systeme". These devices comprise a package made up of a magnetic shielding case containing a magnetic bubble memory chip and coils surrounding the chip for applying a rotating magnetic field thereto, together with permanent magnet means arranged to apply a bias magnetic field to the magnetic bubble memory chip. They will hereinafter be referred to as magnetic bubble memory packages.

As described in the article in "Elektronik", one or more magnetic bubble memory packages may be arranged together with the associated operating and control circuitry on a circuit board to form part of an electrical appliance. A bubble memory system in which a plurality of bubble memory chips together with the associated control circuitry are arranged on a pluggable card is also described in US—A—4 156 934, and an integrated device in which the magnetic bubble memory and the control and operating circuitry are combined in a single chip is described in US—A—3 786 445.

It has also been proposed to incorporate a magnetic bubble memory package in a cassette, to form a readily removable and freely transportable memory unit, which can serve as a portable data recorder for entering data in a computer. Such a cassette is described by H. Maegawa et al, "Application of magnetic bubble memory (bubble cassette)", The Institute of Electronics and Communication of Japan, EC—79—49, December 21, 1979, pages 67—72 and consists of a magnetic bubble memory package enclosed in a protective housing, comprising the cassette body, provided with mounting and connection means enabling the cassette to be readily mounted and demounted in a memory control unit that incorporates driving, read and write and bubble control circuitry for the package and also includes a sense amplifier.

The bubble information stored in a magnetic bubble memory chip might be destroyed if it is subjected to an external noise magnetic field. In a bubble memory package the chip is protected from such magnetic fields by the magnetic shielding case, which is normally such that the bubble information is not destroyed even when the package is subjected to magnetic fields whose strength is from 4,000 to 20,000 A/m, and in the package described in the IBM publication referred to above a double shielding layer consisting of two layers of magnetic material in contact is used.

It is found however that for a bubble memory cassette the magnetic shielding of the bubble memory package therein may not be sufficient, even when enclosed in the housing, to afford the degree of protection necessary to resist the effects of external noise magnetic fields of the strength to which the cassette may be subjected in use.

The present invention provides an improved design of bubble memory cassette that can be safely removed from the memory operating unit and freely transferred in day-to-day use without undue danger of data loss.

In addition it is desirable to provide a magnetic bubble memory cassette with good heat dissipating means, so as to obtain a good bias margin, and to provide means for protecting against electrostatic destruction of bubble information.

According to the present invention, there is provided a magnetic bubble memory cassette comprising a memory package accommodated in a housing structure, the memory package being made up of a magnetic shielding case containing a magnetic bubble memory chip and coils surrounding that chip for applying a rotating magnetic field thereto and also containing permanent magnetic means arranged to apply a bias magnetic field to the magnetic bubble memory chip; the cassette having mounting and connecting means whereby it can be removably mounted on a memory operating unit provided with driving, write and read circuitry for the memory chip, so as to bring the memory chip into operative connection with the said circuitry; characterised in that the cassette also comprises an IC package comprising a sense amplifier associated with the memory chip, the memory package and the IC package being mounted on a printed circuit board within the housing structure and operatively connected to the said mounting and connecting means; in that the housing structure is composed of first and second opposed case members which together surround the said memory package and IC package; and in that two plate-form magnetic shielding parts are mounted, within the said housing structure and against respective opposed surfaces of the said first and second members, so as to be located respectively to opposite sides of and spaced from the said memory package and so as to extend substantially parallel to the said magnetic bubble memory chip therebetween.

Surprisingly it was found that merely providing a space between the magnetic shielding case of the package and the protective housing is not adequate.

Reference will now be made, by way of example, to the accompanying diagrammatic drawings, wherein:

Figure 1 is a schematic circuit diagram of a memory system employing a magnetic bubble memory device embodying the present invention;

Figure 2 shows a perspective view of a first magnetic bubble memory device embodying the present invention;

Figure 3 shows an exploded perspective view of the device of Figure 2;

Figure 4 shows a cross-sectional view corresponding to the plane indicated by lines IV—IV in Figure 2;

Figure 5 shows a partially cut-away view of a component of the device shown in Figure 3;

Figure 6 is a graph illustrating experimental results;

Figure 7 illustrates graphically an external magnetic field of a standard permanent magnet;

Figure 8 is a graph illustrating the experimental results obtained by using the permanent magnet of Figure 7;

Figure 9 is a graph showing temperature characteristics of an operating margin of a magnetic bubble; and

Figure 10 shows an exploded view of a second magnetic bubble memory device embodying the present invention.

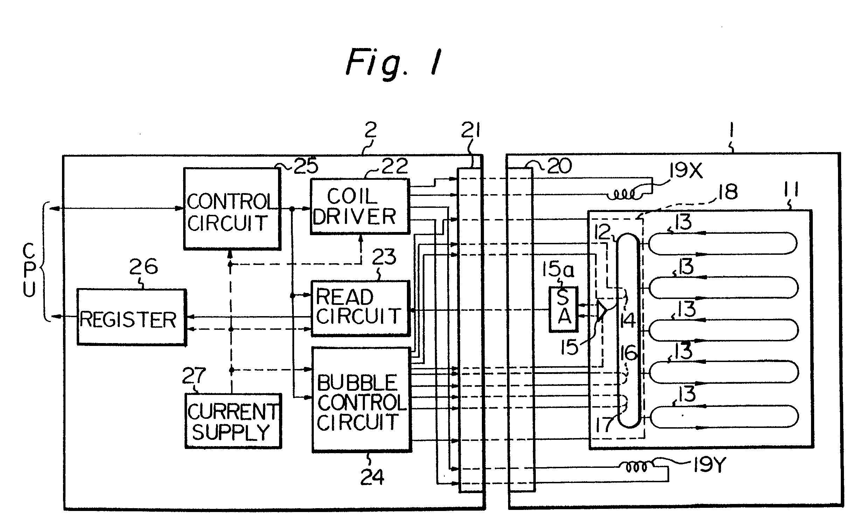

In the system of Figure 1, a magnetic bubble memory cassette 1 can be freely mounted on or demounted from a memory operating unit 2 by means of a connectors 20 and 21.

In the cassette 1, a magnetic bubble memory chip 11 comprises a major loop 12 acting as an information line, minor loops 13 acting as information storage loops, a replicator 14; a detector 15, an eraser 16, a generator 17 and a transmission control conductor pattern 18. A sense amplifier 15a senses an output signal produced by the detector 15. Coils 19X and 19Y generate a rotating magnetic field so as to transfer magnetic bubbles. The coils 19X and 19Y are orthogonal to one another and are wound on the magnetic bubble memory chip 11. In addition, permanent magnets (not shown) are provided so as to generate a bias magnetic field.

In the operating unit 2, a coil driver circuit 22 drives the coils 19X and 19Y of the cassette 1 by supplying a sine-wave or rectangular-wave current; a read circuit 23 is connected to the sense amplifier 15a of the cassette 1; 24 is a bubble control circuit for the replicator 14, the eraser 16, the generator 17 and the transmission control conductor pattern 18. In more detail, the bubble control circuit 24 comprises: a circuit for supplying a current to the replicator 14 so as to split a magnetic bubble; a circuit for supplying a current to the detector 15 so as to detect the presence of a magnetic bubble; a circuit for supplying a current to the eraser 16 so as to erase an unnecessary magnetic bubble; and a circuit for supplying a current to the generator 17 so as to generate a magnetic bubble. 25 is a control circuit for controlling the coil driver circuit 22, the read circuit 23 and the bubble control circuit 24 based upon indication signals from a central processing unit (CPU) which is not shown in Figure 1. 26 is a register and 27 is a current supplying circuit for the circuits 22, 23, 24 and 25 and the register 26. In use of this system of Figure 1, the cassette 1 which is relatively small in size and weight is connected to the operating unit 2 via the connectors 20 and 21 as occasion demands.

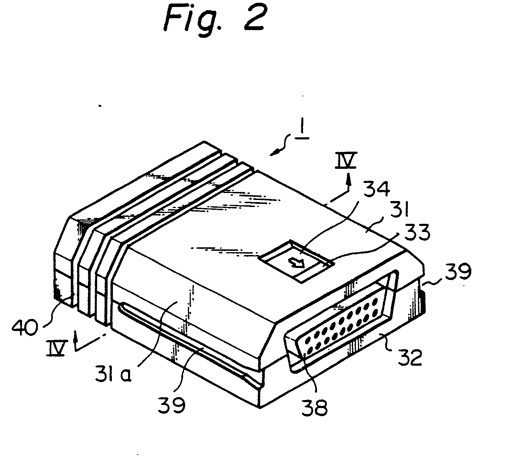

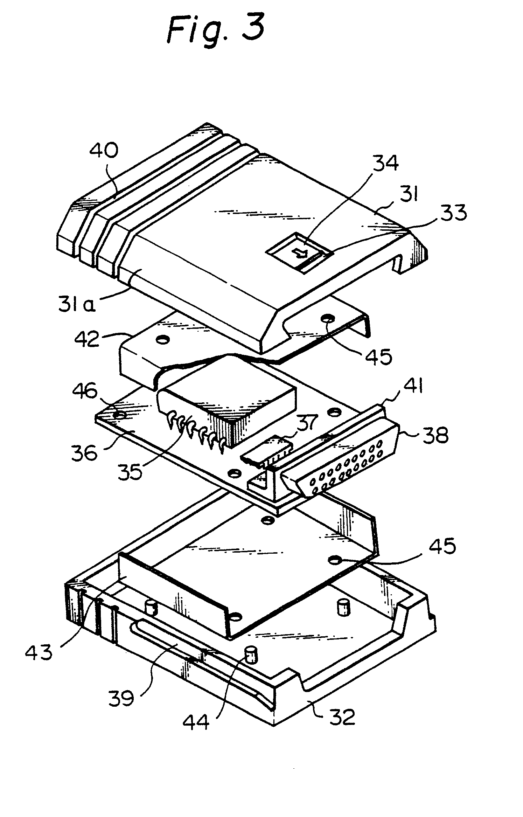

The device of Figures 2 and 3 has a housing structure which comprises moulded upper and lower casing members 31 and 32 which abut at their edges to form the outer casing of a cassette 1. In this design, the outer surface 31a of the upper casing member 31 is asymmetric and has large chamfers so as to prevent the cassette 1 from being turned upside down and incorrectly inserted into the body device 2 (Figure 1). 33 is a recess; 34 is a slide plate located slidably within the recess 33 for inhibiting the write operation; 35 is a package containing a magnetic bubble memory chip (not shown) and other components as explained below. 36 is a printed-circuit board on which the package 35 and an IC package 37 serving as the sense amplifier 15a (Figure 1) are mounted; and 38 is a connector. In this case, the connector 38 is female, so that fingers or the like cannotdirectly come in contact with the pins, which helps to avoid electrostatic destruction of the IC package 37. Grooves 39 serve to prevent a wrong cassette from being inserted into the body device 2 (Figure 1). In this case, the widths of the two grooves 39, on opposite sides respectively, are different from each other. Further, grooves 40 serve to prevent the cassette 1 from sliding at an undesired time and to facilitate the mounting or demounting of the cassette 1 to the body device 2 (Figure 1), and 41 is a base for mounting the connector 38.

It should be noted that the package 35 includes a magnetic shielding case (not shown) therein. However, such a shielding case may not be enough to prevent damage from a strong external noise magnetic field to which the magnetic bubble memory chip (not shown) may be subjected.

The illustrated embodiment of the invention therefore includes magnetic shielding members 42 and 43 which are preferably made of a permalloy, that is, a ferromagnetic material having a high permeability, or of pure iron.

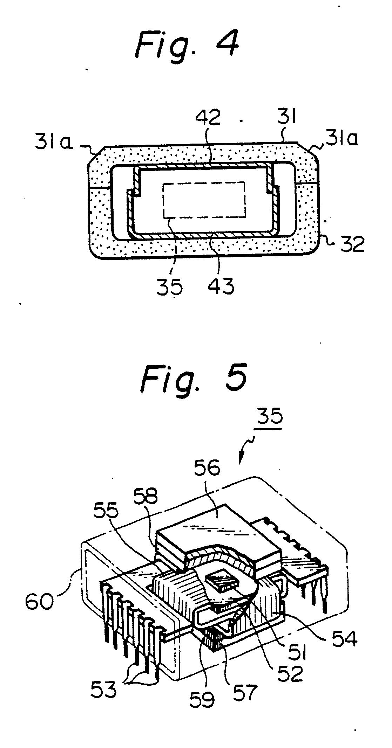

Each of the magnetic shielding plates 42 and 43 is bent at opposite edges thereof to provide side wall portions such that the plates have approximately U-shaped cross-sections (Figure 4). When the casing members 31 and 32 are combined, the inner face of the upper member 31 is spaced from the package 35 by at least 3 mm, and the printed-circuit board 36 is spaced from the lower member 32 by at least 3 mm also. The magnetic shielding plates 42 and 43 are located respectively in these spaces, with their main, base portions parallel to the memory chip therebetween.

The magnetic shielding plate is fixedly mounted on the inner face of the lower casing member 32 by inserting salient portions 44 of the member 32 into apertures 45 of the magnetic shielding plate 43 and by heat caulking protruding parts of the salient portions 44. In addition, the printed-circuit board 36 is fitted (by means of apertures 46) and fixed to the said salient portions 44 of the lower casing member 32.

In a similar manner the magnetic shielding plate 43 is mounted on the inner face of the upper casing member 31.

As illustrated in Figure 4, which is a cross-sectional view taken along line IV—IV of Figure 2, respective sidewall portions of the magnetic shielding plates 42 and 43, which portions project towards one another across the interior of the cassette, overlap so that the package 35 is surrounded by the plates 42 and 43 together, thereby providing an excellent magnetic shield effect.

Figure 5 is a partially cutaway view of the package 35 of Figure 3. In Figure 5, a magnetic bubble memory chip 51 is shown mounted on an insulating substrate 52. External terminals of the magnetic bubble chip 51 are connected, by way of a printed-circuit board, to lead terminals 53; X- and Y-coils 54 and 55 respectively are for generating a rotating magnetic field so as to move bubbles within the magnetic bubble memory chip 51; 56 and 57 are permanent magnets for applying a bias magnetic field so as to stably maintain bubbles within the memory chip 51; 58 and 59 are magnetic field regulating plates; and 60 is a package casing which serves also as a magnetic shielding case.

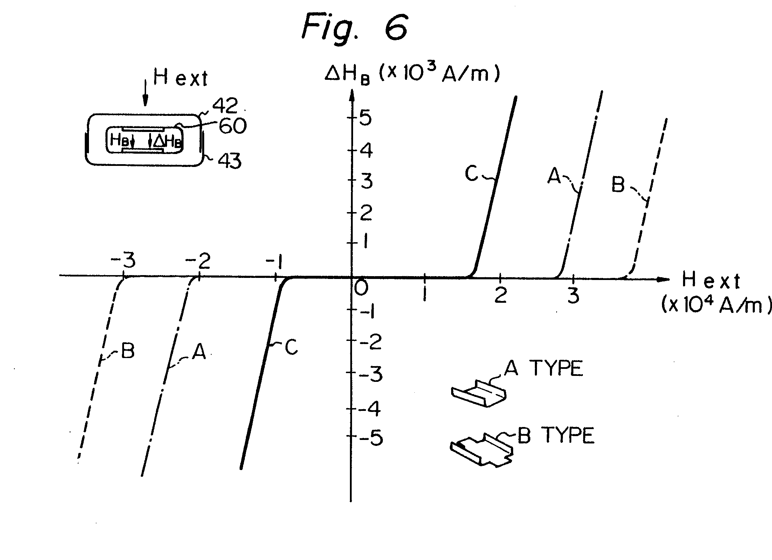

Figure 6 is a graph showing experimental results. In Figure 6, the external magnetic field $H_{ext}$ appearing at the surface of the upper casing member 31 or the lower casing member 32 is shown in the abscissa, while fluctuation $\Delta H_B$ of the bias magnetic field $H_B$ ($H_B = 14000$ A/m) is shown in the ordinate. In Figure 6, line A represents characteristic of the cassette 1 with magnetic shielding plates 42 and 43 of the form illustrated as Type A in Figure 6, made of permalloy (45Ni-Fe) of 0.5 mm thickness; line B represents the characteristics of the cassette 1 with magnetic shielding plates 42 and 43 of the form illustrated as Type B in Figure 6, made of pure iron of 0.3 mm thickness; and line C represents the characteristics of the cassette 1 without magnetic shielding plates 42 and 43. As can be understood from Figure 6, the cassettes represented by lines A and B exhibit an excellent magnetic shield effect, greatly improved as compared with the cassette represented by line C that lacks the magnetic shielding parts required in accordance with the present invention.

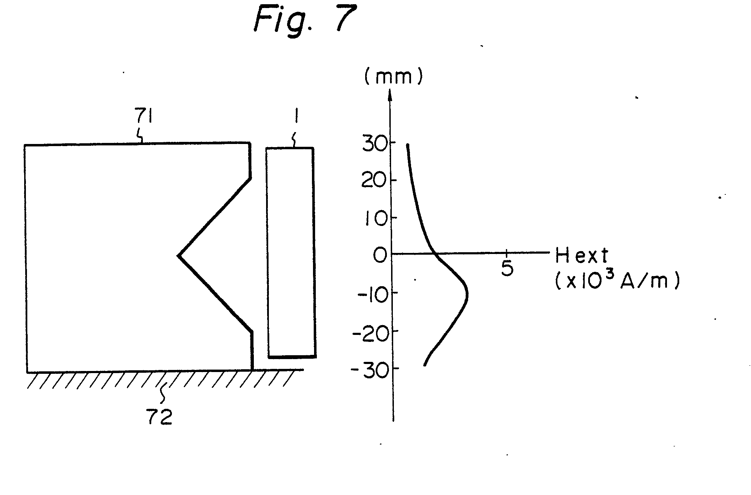

In addition, Figure 7 is a graph showing an external magnetic field of a standard permanent magnet 71. The standard permanent magnet 71 is placed on an iron plate 72, and a cassette 1 (such as that of Figures 2 and 3) is positioned at a distance of about 5 mm from the magnet 71, there being a spacing between the cassette 1 and the iron plate 72 of about 5 mm also. In this state, at the surface of the cassette 1 facing the standard permanent magnet 71, distribution of a magnetic field is shown in Figure 7.

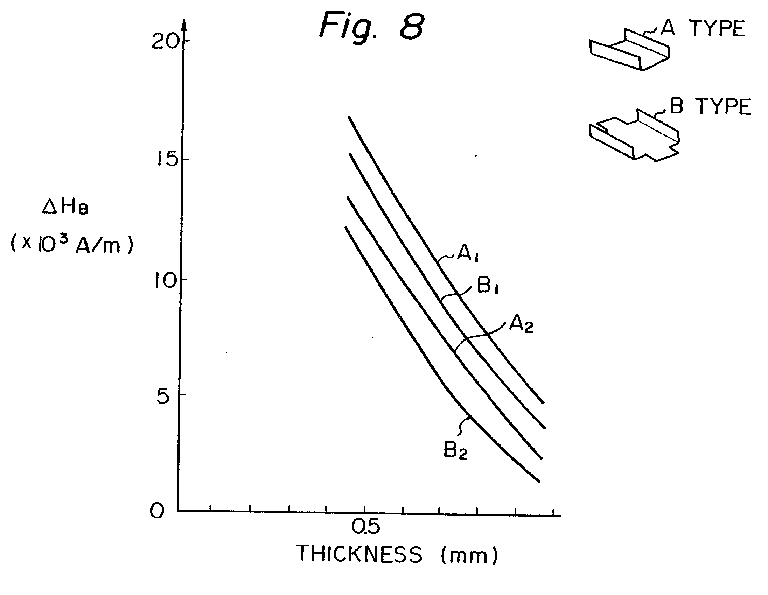

Figure 8 is a graph showing experimental results obtained by using the standard permanent magnet 71 of Figure 7. In Figure 8, the thickness of a magnetic shielding plate (42, 43) is shown in the abscissa, while disturbance $\Delta H_B$ of a bias magnetic field is shown in the ordinate. Line $A_1$ represents the characteristics in the case wherein magnetic shielding plates of the illustrated Type A made of a permalloy, are used; line $B_1$ represents the characteristics in the case wherein magnetic shielding plates of Type B, made of a permalloy, are used; line $A_2$ represents the characteristics wherein A-type magnetic shielding plates made of pure iron are used; and line $B_2$ represents the characteristics wherein B-type magnetic shielding plates made of pure iron are used. As is understood from Figure 8, the magnetic shielding plates made of pure iron exhibit greater magnetic shielding effect than the magnetic shielding plates made of a permalloy. In addition, as the thickness of the magnetic shielding plates is increased, so is the magnetic shielding effect thereof.

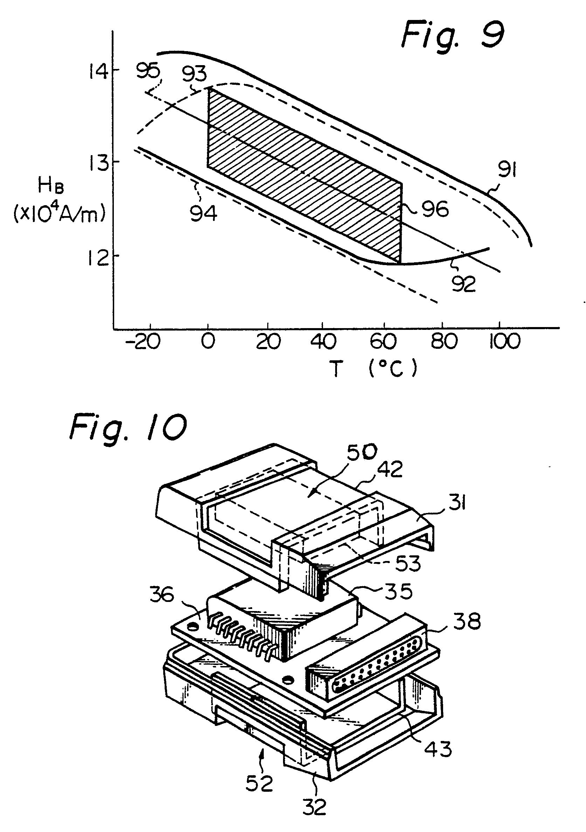

Figure 9 is a graph for explaining the temperature characteristics of an operating margin of a magnetic bubble with regard to a magnetic bubble of a 3 µm diameter. In Figure 9, temperature T is plotted as the abscissa while bias magnetic field $H_B$ applied to the magnetic bubble is plotted as the ordinate. The spacing between solid lines 91 and 92 represents an operating margin in the case where a magnetic field for driving the magnetic bubble, that is, a rotating magnetic field, is large. In this case, at a high temperature and at a low bias magnetic field, since the replicator 14 (Figure 1) can easily generate a magnetic bubble, the margin is small. On the other hand, the space surrounded by broken lines 93 and 94 serves to indicate an operating margin in the case where a rotating magnetic field is small. In this case, at a low temperature and at a high bias magnetic field, since saturation magnetization ($4\pi M_s$) of the magnetic crystal is increased so that magnetic bubbles easily disappear, the margin is small. Accordingly, a shaded area 96 represents a preferred normal operating area. Additionally in Figure 9, a dot and dash line 95 represents the temperature characteristics of a bias magnetic field. Thus it can be seen that the bias margin of a magnetic bubble is somewhat small and dependent upon the temperature. In consideration of the above, it is preferable to restrict any temperature variation of a magnetic bubble memory chip. For this purpose, in a cassette embodying the present invention, means for dissipating heat are preferably provided.

In Figure 10, cassette components which are substantially the same as those of Figure 3 are denoted by the same references. As illustrated in Figure 10, the upper casing member 31 and the lower casing member 32 have apertures 50 and 52, respectively so as to expose outer surface portions of the magnetic shielding plates 42 and 43 to the open air outside the cassette. In addition, a plate 53 of a material of high thermal conductivity such as aluminium or an alloy thereof is provided. This plate 53 can be fixed to plate 42 and contacts the package 35, which enhances the heat dissipating effect, when the casing members 31 and 32 are combined. Note that fins, of a high heat-conductive material, could be used instead of the plate 53.

Further, it is preferable that the above-mentioned upper and lower casing members are made of a mixture containing a carbon material and/or coated with metal, such as nickel, in order to protect the memory chip against damage from electrostatic effects.

## Claims

1. A magnetic bubble memory cassette (1) comprising a memory package (35) accommodated in a housing structure, the memory package being made up of a magnetic shielding case (60) containing a magnetic bubble memory chip (51) and coils (54, 55) surrounding that chip for applying a rotating magnetic field thereto and also containing permanent magnet means (56, 57) arranged to apply a bias magnetic field to the magnetic bubble memory chip; the cassette having mounting and connecting means whereby it can be removably mounted on a memory operating unit (2) provided with driving, write and read circuitry for the memory chip, so as to bring the memory chip into operative connection with the said circuitry; characterised in that the cassette also comprises an IC package (37) comprising a sense amplifier associated with the memory chip, the memory package and the IC package being mounted on a printed circuit board (36) within the housing structure and operatively connected to the said mounting and connecting means; in that the housing structure is composed of first and second opposed case members (31, 32) which together surround the said memory package and IC package; and in that two plate-form magnetic shielding parts (42, 43) are mounted, within the said housing structure and against respective opposed surfaces of the said first and second members, so as to be located respectively to opposite sides of and spaced from the said memory package and so as to extend substantially parallel to the said magnetic bubble memory chip therebetween.

2. A cassette as claimed in claim 1, wherein the spacing between the inner face of the upper case member (31) and the package (35), and between the printed-circuit board (36) and the lower case member (32) is in each case at least 3 mm.

3. A cassette as claimed in claim 1 or claim 2, wherein the plate-form magnetic shielding parts are base portions of respective magnetic shielding members, one of which has side-wall portions which project across the interior of the cassette towards the other magnetic shielding members.

4. A cassette as claimed in claim 3, wherein the said other magnetic shielding member has side-wall portions which project, across the interior of the cassette, towards the said one of the magnetic shielding members.

5. A cassette as claimed in claim 4, wherein such side-wall portions of the said one magnetic shielding member overlap with such side-wall portions of the other magnetic shielding member, so that the said package is surrounded by the material of the said magnetic shielding members.

6. A cassette as claimed.in any preceding claim, wherein the said magnetic shielding parts are made of a permalloy.

7. A cassette as claimed in any one of claims 1 to 5, wherein the said magnetic shielding parts are made of pure iron.

8. A cassette as claimed in any preceding claim, wherein the said housing structure is formed with at least one aperture for exposing an outer surface portion of at least one of the said magnetic shielding parts to air outside the cassette.

9. A cassette as claimed in claim 8, wherein heat dissipating means are arranged between the said package and one of the said magnetic shielding parts.

10. A cassette as claimed in claim 9, wherein the said heat dissipating means are arranged at an upper surface of the said package, which surface is remote from the said printed-circuit board.

11. A cassette as claimed in claim 9 or 10, wherein the said heat-dissipating means comprise a plate made of material of high thermal conductivity.

12. A cassette as claimed in claim 9 or 10, wherein the said heat dissipating means comprise fins made of material of high thermal conductivity.

13. A cassette as claimed in claim 11 or 12, wherein the material of the said heat dissipating means is aluminium or an aluminium alloy.

14. A cassette as claimed in any preceding claim, wherein the said housing structure is made of a mixture of materials, one of which is a carbon material, such as to protect the magnetic bubble memory chip against damage from electrostatic effects.

15. A cassette as claimed in any preceding claim, wherein the said housing structure is coated with a metal, so as to protect the magnetic bubble memory chip against damage from electrostatic effects.

## Revendications

1. Cassette de mémoire à bulles magnétiques (1) comprenant un bloc mémoire (35) disposé dans une structure de logement, le bloc mémoire étant constitué d'un boîtier de blindage magnétique (60) contenant une puce de mémoire à bulles magnétiques (51) et des bobines (54, 55) entourant cette puce afin de lui appliquer un champ magnétique tournant et contenant également des aimants permanents (56, 57) disposés de façon à appliquer un champ magnétique de polarisation à la puce de mémoire à bulles magnétiques; la cassette possédant des moyens de montage et de connexion de façon qu'on puisse la monter de manière amovible sur une unité (2) d'exploitation de mémoire dotée d'un circuit d'excitation, d'écriture et de lecture pour la puce de mémoire, ain de mettre la puce de mémoire en connexion active avec ledit circuit; caractérisée en ce que: la cassette comprend également un bloc circuit intégré (37) comprenant un amplificateur de lecture associé à la puce de mémoire, le bloc mémoire et le bloc circuit intégré étant montés sur une plaquette de circuit imprimé (36) disposée à l'intérieur de la structure de logement et fonctionnellement connectée auxdits moyens de montage et de connexion; en ce que la structure de logement est constituée d'un premier et d'un deuxième élément de boîtier opposés (31, 32) qui, ensemble, entourent ledit bloc mémoire et ledit bloc circuit intégré; et en ce que deux parties de blindage magnétique du type plates-formes (42, 43) sont montées, à l'intérieur de la structure de logement et contre les surfaces respectivement en regard desdits premier et deuxième éléments, de manière à être disposées respectivement sur les côtés opposés dudit bloc mémoire et à une certaine distance de celui-ci et de façon à s'étendre sensiblement parallèlement à ladite puce de mémoire à bulles magnétiques qui est entre elles.

2. Cassette selon la revendication 1, où l'écartement entre la face interne de l'élément de boîtier supérieur (31) et le bloc (35) et l'écartement entre la plaquette de circuit imprimé (36) et l'élément de boîtier inférieur (32) sont, dans chaque cas, d'au moins 3 mm.

3. Cassette selon la revendication 1 ou 2, où les parties de blindage magnétique du type plates-formes sont des parties de base d'éléments de blindage magnétique respectifs, dont l'un possède des parties de paroi latérale qui font saillie sur l'intérieur de la cassette en direction de l'autre élément de blindage magnétique.

4. Cassette selon la revendication 3, où ledit autre élément de blindage magnétique possède des parties de paroi latérale qui font saillie, sur l'intérieur de la cassette, en direction dudit premier des éléments de blindage magnétique.

5. Cassette selon la revendication 4, où ces parties de paroi latérale dudit premie élément de blindage magnétique chevauchent les parties de paroi latérale de l'autre élément de blindage magnétique, si bien que ledit bloc est entouré par le matériau desdits éléments de blindage magnétique.

6. Cassette selon l'une quelconque des revendications précédentes, où lesdites parties de blindage magnétique sont faites en Permalloy.

7. Cassette selon l'une quelconque des revendications 1 à 5, où lesdites parties de blindage magnétique sont faites en fer pur.

8. Cassette selon l'une quelconque des revendications précédentes, où ladite structure de logement est dotée d'au moins une ouverture servant à exposer, à l'air se trouvant à l'extérieur de la cassette, une partie de surface extérieure d'au moins une desdites parties de blindage magnétique.

9. Cassette selon la revendicaton 8, où des moyens de dissipation de chaleur sont disposés entre ledit bloc et une desdites parties de blindage magnétique.

10. Cassette selon la revendication 9, où lesdits moyens de dissipation de chaleur sont disposés au niveau d'une surface supérieure dudit bloc, laquelle surface est éloignée de ladite plaquette de circuit imprimé.

11. Cassette selon la revendication 9 ou 10, où lesdits moyens de dissipation de chaleur comprennent une plaque faite d'un matériau à haute conductivité thermique.

12. Cassette selon la revendication 9 ou 10, où lesdits moyens de dissipation de chaleur comprennent des ailettes faites d'un matériau à haute conductivité thermique.

13. Cassette selon la revendication 11 ou 12, où le matériau desdits moyens de dissipation de chaleur est l'aluminium ou un alliage d'aluminium.

14. Cassette selon l'une quelconque des revendications précédentes, où ladite structure de logement est faite d'un mélange de matériaux, dont un est un matériau à base de carbone, de manière à protéger la puce de mémoire à bulles magnétiques contre les dommages venant des effets électrostatiques.

15. Cassette selon l'une quelconque des revendications précédentes, où ladite structure de logement est revêtue à l'aide d'un metal afin de protéger la puce de mémoire à bulles magnétiques contre les dommages venant des effets électrostatiques.

## Patentansprüche

1. Magnetblasenspeicherkassette (1) mit einer Speicherpackung (35), die in einer Gehäusestruktur aufgenommen ist, wobei die Speicherpackung aus einem magnetisch abschirmenden Gehäuse (60) hergestellt ist, das ein Magnetblasenspeicherchip (51) und Spulen (54, 55) enthält, die das Chip umgeben, um ein rotierendes Magnetfeld auf dieses anzuwenden, und ferner Permanentmagneteinrichtungen (56, 57) enthält, die angeordnet sind, um ein magnetisches Vorspannungsfeld auf das Magnetblasenspeicherchip anzuwenden; wobei die Kassette Montage- und Verbindungseinrichtungen aufweist, wodurch sie entfernbar auf einer Speicherbetriebseinheit (2) montiert ist, die Treib-Schreib- und Leseschaltungen für das Speicherchip enthält, um so das Speicherchip in Betriebsverbindung mit der genannten Schaltung zu bringen; dadurch gekennzeichnet, daß die Kassette ferner eine IC-Packung (37) enthält, die einen Leseverstärker umfaßt, der dem Speicherchip zugeordnet ist, die Speicherpackung und die IC-Packung auf einer gedruckten Schaltungskarte (36) innerhalb der Gehäusestruktur montiert und wirkungsmäßig mit der genannten Montage- und Verbindungseinrichtung verbunden sind; und daß die Gehäusestruktur aus ersten und zweiten, gegenüberliegenden Gehäuseteilen (31, 32) zusammengesetzt ist, welche gemeinsam die Speicherpackung und IC-Packung umgeben; und daß zwei plattenförmige magnetisch abschirmende Teile (42, 43) innerhalb der genannten Gehäusestruktur und gegen jeweils gegenüberliegende Oberflächen der genannten ersten und zweiten Teile montiert sind, um so jeweils auf gegenüberliegenden Seiten von und mit Abstand von der genannten Speicherpackung angeordnet zu sein und sich so im wesentlichen parallel zu dem dazwischen befindlichen Magnetblasenspeicherchip zu befinden.

2. Kassette nach Anspruch 1, bei welcher der Abstand zwischen der inneren Oberfläche des oberen Gehäuseteils (31) und der Packung (35) und zwischen der gedruckten Schaltungskarte (36) und dem unteren Gehäuseteil (32) in jedem Gehäuse wenigstens 3 mm beträgt.

3. Kassette nach Anspruch 1 oder 2, bei welcher die plattenförmigen magnetisch abschirmenden Teile Basisabschnitte von jeweiligen magnetisch abschirmenden Teilen sind, von denen eines Seitenwandabschnitte aufweist, die quer zu dem Inneren der Kassette zu dem anderen magnetisch abschirmenden Teil vorstehen.

4. Kassette nach Anspruch 3, bei welcher das genannte andere magnetisch abschirmende Teil Seitenwandabschnitte aufweist, die quer zu dem Inneren der Kassette zu dem genannten anderen magnetisch abschirmenden Teil vorstehen.

5. Kassette nach Anspruch 4, bei welcher solche Seitenwandabschnitte des genannten einen magnetisch abschirmenden Teils mit solchen Seitenwandabschnitten des anderen magnetisch abschirmenden Teils so überlappen, daß die genannte Packung von dem Material der genannten magnetisch abschirmenden Teile umgeben ist.

6. Kassette nach einem der vorhergehenden Ansprüche, bei welcher die genannten magnetisch abschirmenden Teile aus Permalloy hergestellt sind.

7. Kassette nach einem der Ansprüche 1 bis 5, bei welcher die genannten magnetisch abschirmenden Teile aus reinem Eisen bestehen.

8. Kassette nach einem der vorhergehenden Ansprüche, bei welcher die genannte Gehäusestruktur mit wenigstens einer öffnung ausgebildet ist, um einen äußeren Oberflächenabschnitt von wenigstens einem der genannten magnetisch abschirmenden Teile der Luft außerhalb der Kassette zu exponieren.

9. Kassette nach Anspruch 8, bei welcher Wärmeableitungseinrichtungen zwischen der genannten Packung und einem der genannten magnetisch abschirmenden Teile angeordnet sind.

10. Kassette nach Anspruch 9, bei welcher die genannte Wärmeableitungseinrichtung an einer oberen Oberfläche der genannten Packung angeordnet ist, welche Oberfläche von der genannten gedruckten Schaltungskarte entfernt ist.

11. Kassette nach Anspruch 9 oder 10, bei welcher die genannte Wärmeableitungseinrichtung eine Platte umfaßt, die aus einem Material hoher thermischer Leitfähigkeit besteht.

12. Kassette nach Anspruch 9 oder 10, bei welcher die genannte Wärmeableitungseinrichtung Rippen umfaßt, die aus einem Material hoher thermischer Leitfähigkeit besteht.

13. Kassette nach Anspruch 11 oder 12, bei welcher das Material der genannten Wärmeableitungseinrichtung Aluminium oder eine Aluminiumlegierung ist.

14. Kassette nach einem der vorhergehenden Ansprüche, bei welcher die genannte Gehäusestruktur aus einer Mischung aus Materialien besteht, von denen eines ein Kohlenstoffmaterial ist, um so das Magnetblasenspeicherchip gegen Beschädigung durch elektrostatische Effekte zu schützen.

15. Kassette nach einem der vorhergehenden Ansprüche, bei welcher die genannte Gehäusestruktur mit einem Metall überzogen ist, um so das Magnetblasenspeicherchip gegen Beschädigung durch elektrostatische Effekte zu schützen.

# Fig. 1

0 055 017

# Fig. 2

# Fig. 3

## Fig. 4

## Fig. 5

Fig. 6

# Fig. 7

Fig. 8

A TYPE

B TYPE

$\Delta H_B$
$( \times 10^3 \text{ A/m} )$

THICKNESS (mm)

0.5

A₁
B₁
A₂
B₂

*Fig. 9*

*Fig. 10*